# FASCICULE DE BREVET EUROPEEN

(11) **EP 1 921 084 B1**
(45) Date de publication et mention de la délivrance du brevet: **02.03.2011**
(21) Numéro de dépôt: 07290888.2
(22) Date de dépôt: 16.07.2007
(51) Int. Cl.: C07F 15/00

(54) **Sels de diazonium polymérisables, procédé de fabrication et utilisations de ceux-ci**
Polmerisierbare Diazoniumsalze, Verfahren zu deren Herstellung und deren Verwendung
Polymerisable diazonium salts, method of manufacturing and use thereof

(30) Priorité: 27.07.2006 FR 0606906
(43) Date de publication de la demande: 14.05.2008
(73) Titulaire: Commissariat à l'Énergie Atomique et aux Énergies Alternatives, 75015 Paris (FR)
(72) Inventeur: Jousselme, Bruno, 93100 Massy (FR); Bidan, Gérard, 38100 Grenoble (FR); De Bettignies, Rémi, 74160 St. Julien en Genevois (FR)
(74) Mandataire: Noel, Chantal Odile

(56) Documents cités:
- BOTTOMLEY, F. ET AL.: "Electrophilic Behaviour of Nitrosyls" J.CHEM.SOC.DALTON TRANS., 1982, pages 1933-1937, XP009080489
- ISIED, S. ET AL.: "Rates of Substitution in Cis and Trans Ruthenium(II) Aquotetraamines" INORGANIC CHEMISTRY, vol. 15, 1976, pages 3070-3075, XP002424377
- WARE, D.C., TAUBE, H.: "Substitution-Induced N-N Coupling for Nitride Coordinated to Osmium(VI)" INORGANIC CHEMISTRY, vol. 30, 1991, pages 4605-4610, XP002424378
- MAGNUSON, R.H., TAUBE, H.: "Synthesis and Properties of Osmium(II) and Osmium(III) Ammine Complexes of ARomatic Nitrogen Heterocycles" J. AM. CHEM. SOC., 1975, pages 5129-5136, XP002424379

## Description

L'invention se rapporte à des sels de diazonium polymérisables ayant des propriétés redox et d'absorption dans le visible à différentes longueurs d'ondes, à leur procédé de fabrication et à leurs utilisations.

La fonctionnalisation, également appelée dans ce qui suit modification, de surfaces conductrices ou semi-conductrices de l'électricité avec des films polymères trouve application dans de nombreux domaines tels que la biologie, l'électronique et les composants optiques.

Il existe à l'heure actuelle un intérêt pour au moins deux types de modifications de surfaces conductrices ou semi-conductrices :
- la modification de surfaces conductrices ou semi-conductrices par des complexes métalliques, d'une part et,
- la fonctionnalisation de surfaces conductrices ou semi-conductrices en utilisant des sels de diazonium, d'autre part.

La modification des surfaces conductrices ou semi-conductrices par des complexes métalliques conduit à des dispositifs hybrides et présente un intérêt important dans le domaine de la conversion d'énergie, du stockage d'informations, de l'optique, ou encore de l'électronique moléculaire.

En effet, les propriétés et le comportement de ces dispositifs électroniques ou optoélectronique hybrides sont fortement influencés par les échanges électroniques entre la partie organique et inorganique, et, par conséquent, par la nature des liaisons chimiques entres les molécules organiques et le semi-conducteur ainsi que par la quantité et la nature du complexe métallique greffé.

Ainsi, dans le domaine de la conversion d'énergie, et plus particulièrement dans les cellules photovoltaïques de type Grätzel, la surface semi-conductrice est modifiée par des complexes métalliques.

Ici, la photoconversion est réalisée grâce aux complexes métalliques qui sont liés aux nanoparticules de TiO₂, SnO₂, ZnO, ou ZrO₂.

Dans ces cellules de type Grätzel, les ligands des complexes comportent des fonctions phosphonates, siloxanes, malonate d'éthyle, éther, cyanide qui interagissent chimiquement avec la surface de nanoparticules de TiO₂, SnO₂, ZnO, ou ZrO₂ pour se greffer au moyen de liaisons de nature covalente ou ionique et donner des monocouches de complexes à la surface.

Le complexe métallique dans ce type de dispositif est le composant actif car il absorbe la lumière visible et réalise la séparation des charges.

En effet, la photo-excitation du complexe métallique (photosensibilisateur) qui absorbe la lumière produit l'injection d'un de ses électrons dans la bande de conduction du semi-conducteur. La réduction du complexe oxydé entraîne la formation de charges positives qui sont transportées vers la contre-électrode au moyen de l'électrolyte conducteur (I₃⁻/I⁻). Le photosensibilisateur oxydé est ensuite réduit par le couple I₃⁻/I⁻ de l'électrolyte pour revenir à son état initial.

L'énergie qui va être générée par cette cellule photovoltaïque va donc dépendre du nombre de photons absorbés par le complexe métallique greffé à la surface de la nanoparticule.

Toutefois, la technique de greffage des complexes dans ce type de dispositif ne permet que de réaliser des monocouches de complexe et donc ne permet pas d'absorber toute l'intensité du spectre solaire.

De plus, l'utilisation de l'électrolyte I₃⁻/I⁻, qui est un liquide, pose un problème majeur. En effet, il est difficile d'obtenir des cellules parfaitement hermétiques qui n'ont pas de fuites de l'électrolyte liquide.

Par ailleurs, dans le cadre du stockage d'informations, la surface semi-conductrice de silicium est modifiée par le greffage de molécules rédox, telles que des porphyrines ou des ferrocènes, sur cette surface.

Les composés organiques greffés sur ces surfaces sont les composés actifs du dispositif puisque ce sont eux qui vont être à l'origine de l'effet mémoire par un stockage de charges.

Cependant, les méthodes de fonctionnalisation développées jusqu'à présent sont exclusivement des méthodes qui impliquent des réactions chimiques telles que l'activation thermique d'un alcool, d'un thiol, d'un dérive méthylhalogéné ou de thiols protégés avec une surface de silicium hydrogénée ou de silicium halogéné, l'hydrosyllilation thermique de complexes métalliques comportant une fonction alcène ou alcyne.

Toutes ces méthodes présentent différents inconvénients, notamment le fait que la fonctionnalisation de surface par ces composés s'effectue à des températures élevées, de l'ordre de 200°C à 400°C, conditions qui ne sont pas compatibles avec tous les composés chimiques.

De plus, ces réactions peuvent aussi être extrêmement coûteuses en produit lorsqu'elles sont réalisées en condition solide.

De même, par ces différentes méthodes, le centre métallique qui présente les propriétés redox est espacé par un pont arylméthylène qui éloigne celui-ci de la surface.

Enfin, toutes ces méthodes ne conduisent qu'à la formation de monocouches et non pas à des polymères.

Cependant, WO2005/86826 A2 décrit la formation de polymères redox sur une surface de silicium. La méthode chimique utilisée consiste à chauffer à une température comprise entre 200°C et 400°C des porphyrines comportant deux fonctions alcyne.

Si ce document décrit bien la formation de polymères redox sur une surface conductrice, cette formation se fait encore par une réaction à températures élevées et ne peut donc pas être appliquée à tous les composés organiques.

Un autre moyen de fonctionnalisation des surfaces conductrices ou semi-conductrices est la fonctionnalisation électrochimique de ces surfaces par des sels de diazonium.

La fonctionnalisation électrochimique par des sels de diazoniums permet d'obtenir des polymères greffés à la surface, généralement de silicium. Elle a été réalisée à partir de sels de diazonium commerciaux qui sont le tétrafluoroborate de 4-nitro ou 4-bromophényldiazonium.

La propriété spécifique de ces sels de diazonium est qu'ils sont greffés de manière covalente avec le silicium et donc forment une interaction forte entre molécules et substrat.

Cependant, cette méthode est limitée car il existe peu de sels de diazonium car ceux-ci sont des composés instables à température ambiante et difficiles à isoler.

De plus, les polymères formés ainsi que les surfaces de semi-conducteurs formées ne peuvent pas être utilisés pour le stockage d'informations ou la conversion d'énergie.

En effet, il n'existe pas à l'heure actuelle de sels de diazonium qui pourraient absorber la lumière visible à différentes longueurs d'ondes et avoir des propriétés redox ou photoredox.

Un autre problème de cette méthode, toujours en raison de la spécificité des sels de diazonium utilisés, est que les films déposés à l'électrode par cette méthode sont de faible épaisseur. Ceci est dû au dépôt de composés non conducteurs sur la surface qui ne permettent pas d'apporter les charges afin de continuer le dépôt électrochimique et conduit donc au dépôt d'un film isolant à la surface du semi-conducteur.

Cette méthode est connue dans la littérature pour la fonctionnalisation de surfaces de silicium, c'est-à-dire de surfaces de semi-conducteurs à bande étroite.

Cependant, cette méthode n'a jamais été décrite pour la modification de semi-conducteurs à larges bandes tels que TiO₂, ZnO, SnO et ZrO₂.

L'invention vise à résoudre les problèmes de l'art antérieur en proposant de nouveaux sels de diazonium greffables et polymérisables présentant des propriétés redox et d'absorption dans le visible à différentes longueurs d'ondes.

Ces nouveaux sels de diazonium permettent la polymérisation électrochimique de nouveaux complexes métalliques qui s'ancrent sur la surface conductrice ou semi-conductrice au moyen d'une liaison covalente puis polymérisent pour former un film conducteur d'épaisseur contrôlable sur des surfaces conductrices ou semi-conductrices, en particulier la surface de nanofils semi-conducteurs de type n.

Ces nouveaux sels de diazonium permettent également la synthèse de polymères à différentes couches de complexes métalliques ainsi que le piégeage de charges à l'intérieur des différentes couches de polymères pour la réalisation de mémoire de stockage d'informations ou pour le transport de charges à l'intérieur des polymères pour servir d'électrolyte solide, et ce à température ambiante.

De plus, ces nouveaux sels de diazonium peuvent être greffés sur des surfaces métalliques, en particulier d'or et de platine, ainsi que sur des nanotubes de carbone de type SWNT ou MWNT, des nanoparticules ...

A cet effet, l'invention a pour objet des sels de diazonium polymérisables caractérisés en en ce qu'ils ont des propriétés redox et d'absorption dans le visible et en ce qu'ils ont la formule générale (I) suivante :

[X^{x+} LₙD_{d} Eₘ (N₂⁺)ₚ] [(B⁻)ₚ₊ₓ]

dans laquelle :
- X est un métal de transition choisi parmi le ruthénium (Ru), l'osmium (Os), le fer (Fe), le cobalt, (Co), et l'iridium (Ir),
- x est un entier valant de 1 à 5 inclus,
- L est un ligand choisi parmi les groupements pyridine, bipyridine, terpyridine, phénanthroline, phénylpyridine, et les mélanges de ceux-ci,
- n est un entier valant de 1 à 5, inclus
- D est un composé espaceur alkyle en C₁-C₅, saturé ou insaturé,
- d= 0 ou 1,
- E est un composé espaceur aromatique ou polyaromatique, pouvant comporter un ou plusieurs hétéroatomes, choisi parmi un groupement benzothiophène, benzofurane, indole, indoline, carbazole, déhydroquinoléine, chromone, julodinine, thiadiazole, triazole, isoxasole, oxazole, thiazole, isothiazole, imidazole, pyrazole, thiazine, triazine, pyrazine, pyridazine, pyrimidine, diazépine, oxazépine, benzotriazole, benzoaxazole, imidazole, benzimidazole, morpholine, pipéridine, pipérazine, azétidine, pyrrolidine, aziridine, un groupement phényle, biphényle, thiophène, bithiophène, furane, bifurane, pyridine, bipyridine, terpydidine, fluorène, fluorénone ou les mélanges de ceux-ci , et
- B est un contre-ion,
- m est un entier valant de 0 à 5 inclus,
- p est un entier.

Comme on le voit à partir de la formule (I), les sels de diazonium de l'invention comprennent un complexe métallique et un ou plusieurs ions diazonium.

De manière classique, le complexe métallique est constitué d'un centre métallique, noté X dans la formule (I), auquel sont reliés des ligands aromatiques ou polyaromatiques, notés L dans la formule (I). Les complexes métalliques peuvent être symétriques c'est-à-dire composés de ligands identiques ou non symétriques c'est-à-dire composés de ligands différents.

Une ou plusieurs fonctions diazonium sont attachées au ligand du complexe métallique soit directement, soit par l'intermédiaire d'un espaceur, noté E dans la formule (I), soit encore par l'intermédiaire d'une premier espaceur, noté D dans la formule (I), espaceur D qui est alors lui-même relié à l'espaceur E et au ligand L.

De par la présence de ce ou de ces diazonium, les sels de l'invention permettent d'obtenir des films de polymère(s) sur des surfaces conductrices ou semi-conductrices.

Par les termes "surface conductrice ou surface semi-conductrice", on entend une surface conductrice ou semi-conductrice de l'électricité.

De préférence, les surfaces conductrices sont des surfaces d'inox, d'acier, de fer, de cuivre, de nickel, de cobalt, de niobium, d'aluminium (notamment lorsqu'il est fraîchement brossé), d'argent, d'or, de platine, d'iridium ou de platine iridié.

De préférence, les surfaces semi-conductrices sont des surfaces de silicium dopé ou non dopé, d'oxyde de titane (TiO₂), d'oxyde d'étain (SnO₂), d'oxyde de zinc (ZnO) ou d'oxyde de zirconium ou zircone (ZrO₂). Elles peuvent également être des surfaces de nanotubes de carbone SWNT ou MWNT ou des nanoparticules.

Mais, de façon plus importante, le film de polymère obtenu grâce aux sels de diazoniums de l'invention, a des propriétés redox réversibles et d'absorption de la lumière visible à différentes longueurs d'ondes, en raison de la présence du complexe métallique.

Dans la formule (I), E est un composé espaceur aromatique ou polyaromatique pouvant comporter un ou plusieurs hétéroatomes tel qu'un groupement benzothiophène, benzofurane, indole, indoline, carbazole, déhydroquinoléine, chromone, julodinine, thiadiazole, triazole, isoxasole, oxazole, thiazole, isothiazole, imidazole, pyrazole, thiazine, triazine, pyrazine, pyridazine, pyrimidine, diazépine, oxazépine, benzotriazole, benzoaxazole, imidazole, benzimidazole, morpholine, pipéridine, pipérazine, azétidine, pyrrolidine, aziridine,

Quant au contre-ion B, tout contre-ion permettant d'obtenir l'électroneutralité de la molécule peut être utilisé, tel qu'un fosylate, un sulfonate, des polymères anioniques, tels que les polystyrènes, les sulfonates, les polyvinyl sulfonates et le Nafion.

De préférence, dans la formule (1), E est un groupement phényle, biphényle, thiophène, bithiophène, furane, bifurane, pyridine, bipyridine, terpydidine, fluorène, fluorénone ou les mélanges de ceux-ci, et B est PF₆ ou BF₄

Des exemples de sels de diazonium préférés selon l'invention ont l'une des formules générales 1-2 à 1-7 suivantes : 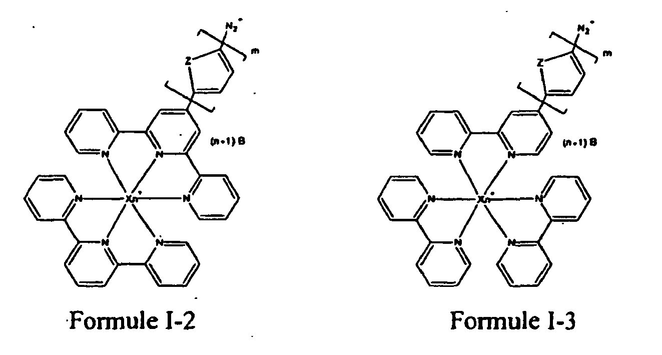 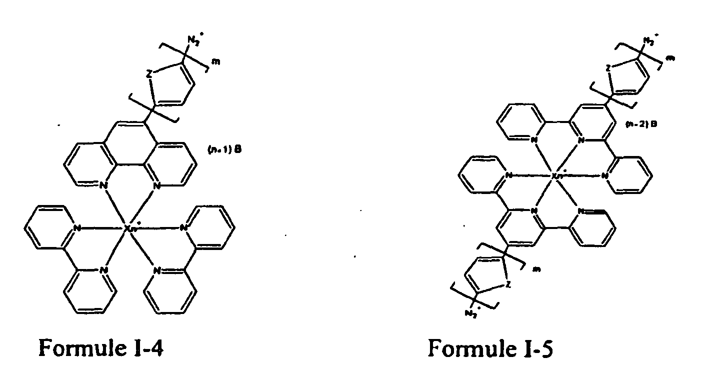 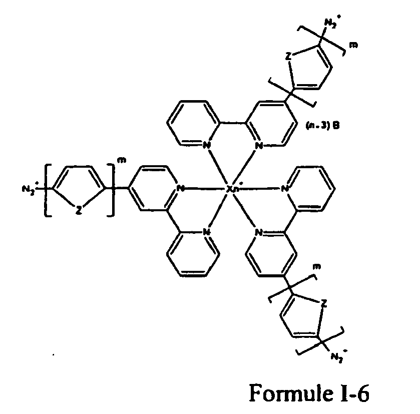 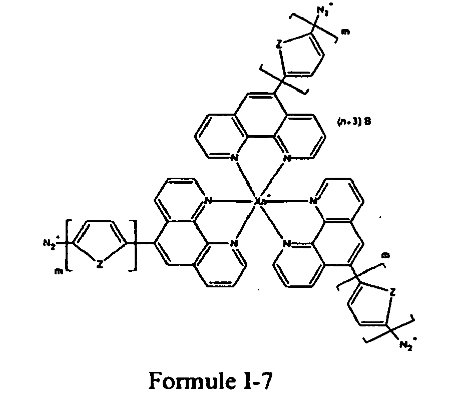 dans lesquelles X est choisi parmi le Ruthénium (Ru), l'Osmium (Os), le fer (Fe), le cobalt (Co), et l'iridium (Ir), Z est CH=CH, S, O, CH=N, N-H,N = N, m est un entier valant de 0 à 5 inclus, et B est de préférence BF₄ ou PF₆.

Dans les formules 1-2 à I-7, l'ion diazonium est lié au complexe métallique par l'intermédiaire de l'espaceur de formule 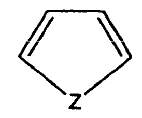 dans laquelle Z peut être CH=CH, S, O, CH=N, N-H,N=N et m est un entier valant de 0 à 5 inclus.

D'autres sels de diazonium préférés selon l'invention dans lesquels le centre métallique X peut être le ruthénium ou l'osmium ont les formules générales 1-8 à I-12 suivantes : 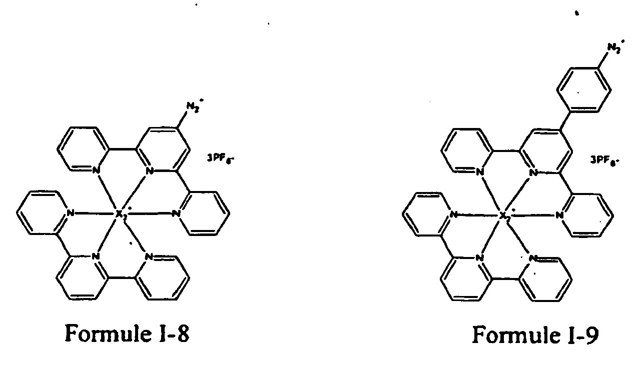 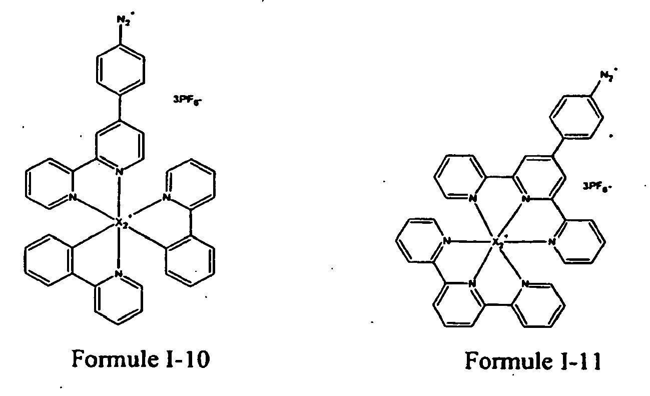 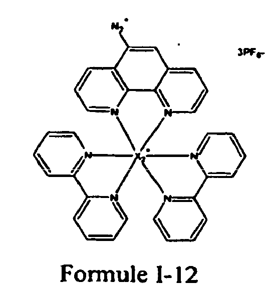 dans lesquelles X est choisi parmi le ruthénium (Ru) et l'osmium (Os).

Dans ces sels de diazonium, le contre-ion B est PF₆ et l'ion diazonium est lié directement au complexe métallique.

Encore d'autres sels de diazonium préférés selon l'invention ont l'une des formules générales I-13 à I-14 suivantes : 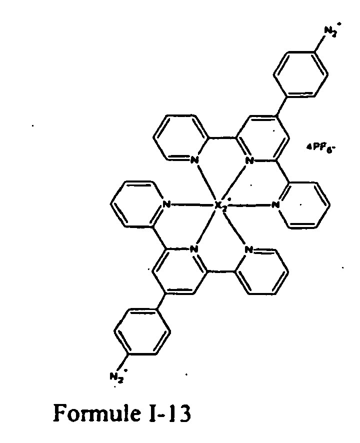 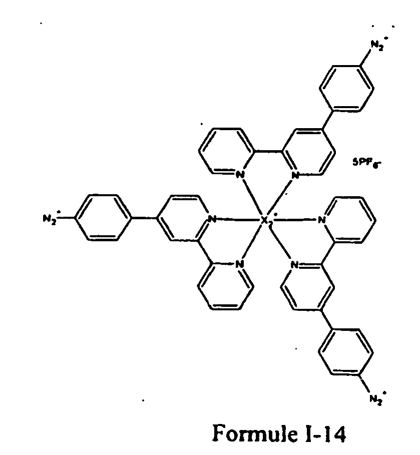 dans lesquelles X est choisi parmi le fer (Fe), le ruthénium (Ru) et l'osmium (Os).

Un sel de diazonium particulièrement préféré selon l'invention a la formule (I-15) : [Ru(bipyridine)₂(bipyridine-phényl-N₂⁺)] [PF₆]₃.

Un autre sel de diazonium particulièrement préféré selon l'invention a la formule (I-16) suivante : [Ir(phénylpyridine)₂(Bipyridine-phényl-N₂⁺)][PF₆]₂ et la formule développée ci-après :

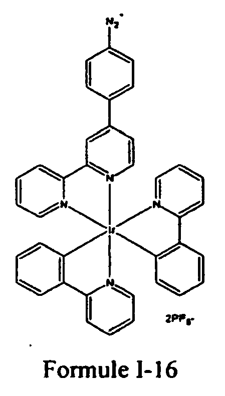

L'approche synthétique générale pour accéder aux sels de diazonium de complexe métallique de l'invention peut être décrite de la manière suivante : dans un premier temps, les complexes métalliques sont synthétisés avec au moins un ligand selon une méthode générale de synthèse des complexes métalliques telle que celle décrite dans New. J. Chem, 1999, 53-61.

Les ligands du complexe métallique peuvent être identiques ou différents. Cependant, ils ont tous au moins une fonction amine aromatique.

Dans un deuxième temps, les fonctions amines sont transformées en ions diazonium N₂⁺, en utilisant du tétrafluoroborate de nitrosium (NOBF₄) comme décrit dans J. Am. Chem. Soc. 2004, 126, 370-378.

Cette méthode a été choisie préférentiellement à la méthode générale d'obtention des sels de diazonium qui est d'utiliser HBF₄/NaNO₂ et qui donne un moins bon rendement de réaction.

Ainsi, l'invention a aussi pour objet un procédé de synthèse de sels de diazonium selon l'invention qui comprend les étapes de : (a) synthèse du complexe métallique voulu de formule XLₙ où tous les ligands L ont au moins une fonction amine aromatique et peuvent être identiques ou différents, et (b) transformation des fonctions amines en ions diazonium N₂⁺ en utilisant NOBF₄.

Les sels de diazonium de l'invention permettent d'obtenir des surfaces conductrices ou semi-conductrices recouvertes de films polymères ayant des propriétés redox réversibles et des propriétés d'absorption dans le visible à différentes longueurs d'ondes, selon la nature du centre métallique X.

La réalisation de telles surfaces présente un grand intérêt dans de nombreux domaines, en particulier pour la fabrication de composant électroniques ou de dispositifs optiques, pour la réalisation de dispositifs utilisables dans le domaine biomédical ou dans les biotechnologies, pour la protection anticorrosion, ainsi que pour toutes les modifications des propriétés superficielles des métaux ou des semi-conducteurs.

Ainsi, dans le cadre de la conversion d'énergie et plus particulièrement des cellules photovoltaïques de type Grätzel, où la photoconversion est réalisée grâce aux complexes métalliques qui sont liés au nanoparticules de TiO₂, les sels de diazonium de l'invention peuvent être utilisés pour former un électrolyte solide, cet électrolyte solide pouvant être composé de plusieurs couches de complexes métalliques, d'une part, et pour former la couche active pour l'absorption des photons, d'autre part.

En effet, grâce aux sels de diazonium de l'invention, le film polymère formé n'est pas isolant comme dans l'art antérieur et un second film de complexe métallique peut être formé sur le premier film polymère formé.

Le fait de disposer d'un électrolyte solide multicouches présente un avantage considérable dans les cellules photovoltaïques de type Grätzel, tout d'abord parce qu'il permet d'obtenir des cellules parfaitement hermétiques qui n'ont pas de fuite d'électrolyte. En effet, dans l'art antérieur, l'électrolyte était liquide.

Ensuite, le fait de pouvoir obtenir plusieurs couches de complexes métalliques différents greffées sur la surface du TiO₂ permet à la cellule de Grätzel d'absorber toute l'intensité du spectre solaire, ce qui n'était pas le cas dans l'art antérieur où la technique de greffage des complexes métalliques ne permettait que de réaliser des monocouches de complexes.

De plus, la possibilité de réaliser des films à différentes couches de composés organiques permet de faciliter l'extraction des charges.

Enfin, grâce aux sels de diazonium de l'invention, on peut contrôler l'épaisseur des films formés.

Mais, les sels de diazonium de l'invention présentent également un grand intérêt dans le stockage d'informations, c'est-à-dire pour la réalisation de mémoires.

Dans ce type d'application, les composés organiques greffés sur la surface sont les composés actifs du dispositif puisque ce sont eux qui vont être à l'origine de l'effet mémoire par un stockage de charges.

Les sels de diazonium de l'invention permettant le greffage électrochimique de tels composés actifs sur les surfaces semi-conductrices, et en particulier sur une surface de silicium, permettent de fonctionnaliser cette surface dans des conditions plus douces avec un plus large choix de composés organiques, ce qui permet d'explorer de nombreuses voies d'amélioration de ces mémoires.

De plus, le coût de cette fonctionnalisation est diminué du fait de la faible quantité de composés nécessaires à la fonctionnalisation.

En effet, les sels de diazonium de l'invention peuvent être greffés sur la surface conductrice ou semi-conductrice par une technique électrochimique et non par une technique chimique comme dans l'art antérieur, la surface semi-conductrice pouvant être une surface d'un semi-conducteur à bande étroite tel que du silicium dopé n ou une surface de semi-conducteur à large bande tel que ZnO.

La méthode de greffage utilisée est une méthode rapide et directe qui se déroule en une seule étape.

Par cette méthode, il est possible de greffer à la surface du semi-conducteur une ou plusieurs couches de monomères et obtenir des polymères sur l'électrode.

Le greffage des sels de diazonium de complexe métallique de l'invention est réalisé à température ambiante dans des conditions potentiodynamiques ou statiques. L'électrode semi-conductrice est plongée dans une solution composée du monomère dégazé dans un solvant tel que CH₃CN, DMF, contenant un sel de fond tel que LiClO₄, NR₄PF₆, NR₄BF₄, où R est une chaîne alkyle en C₁-C₅, ramifiée ou non, ou des liquides ioniques tels que le sel de tétrafluoroborate de 1-butyl-3-méthylimidazolium, le sel de trifluorométhanesulfonate de 1-ethyl-3-methylimidazolium, le sel de bromure de (4-pyridyl)pyridinium

Par polarisation négative de l'électrode, on obtient la réduction du sel de diazonium qui conduit à la formation d'un radical. Ce radical va réagir avec les liaisons hydrogène du support pour former une liaison covalente selon un processus radicalaire. Cette réaction est reliée au nombre d'électrons injectés à l'électrode dans la solution. Il va ainsi être possible de contrôler l'épaisseur du film déposé qui peut atteindre plusieurs centaines de nanomètres.

L'obtention de films de polymères d'épaisseur pouvant aller de quelques nanomètres à plusieurs centaines de nanomètres est due à la spécificité de sels de diazonium de l'invention.

En effet, les sels de diazonium de l'invention présentent deux vagues de réduction réversible entre -1,6V et -2V en raison de leurs propriétés redox. Ces propriétés redox permettent d'acheminer des électrons à la surface du film déjà déposé, et ainsi non seulement de propager la polymérisation pour obtenir l'épaisseur voulue, mais aussi d'obtenir un film organique conducteur à la surface de l'électrode, ce qui permet de déposer, si on le souhaite, un ou plusieurs films supplémentaires ayant un centre métallique X identique ou différent.

La propagation de la polymérisation se fait selon le schéma 1 suivant :

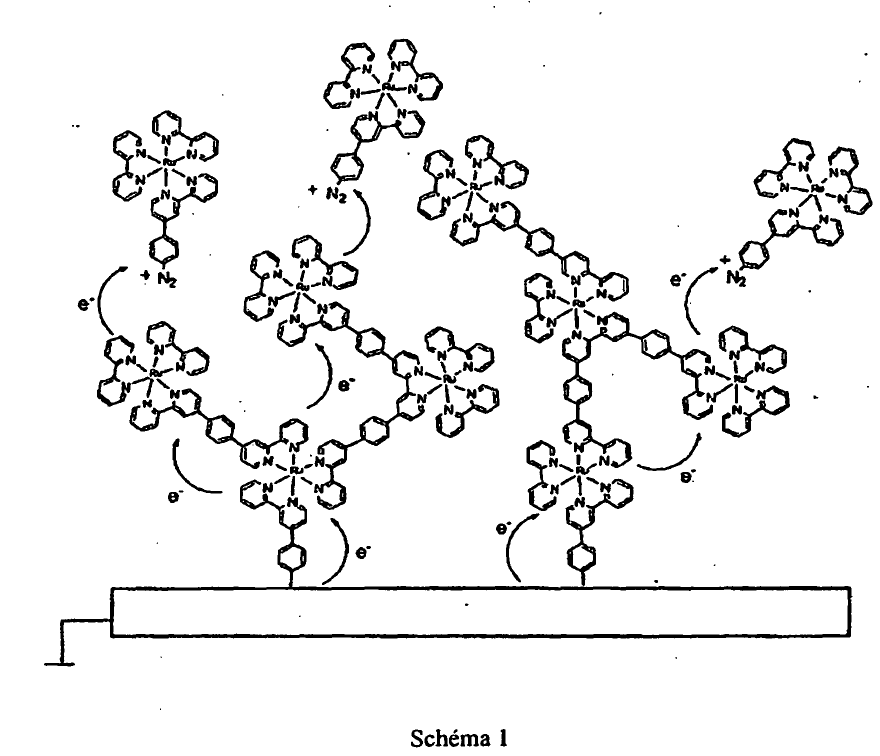

Cette polymérisation procède par greffage des radicaux sur les composés aromatiques, comme on le voit à partir du schéma 1. Les polymères obtenus par cette méthode sont donc des polymères entièrement conjugués.

Cette méthode présente tous les avantages de l'adressage électrique que n'a pas la méthode chimique, c'est-à-dire permet un contrôle du taux des composés déposés, leur positionnement, etc, contrairement à la méthode de l'art antérieur.

De plus, les sels de diazonium de l'invention permettent de déposer des couches de complexes métalliques différents, ayant des propriétés redox différentes, afin d'augmenter le stockage des charges et donc les performances de la mémoire.

En effet, grâce aux propriétés redox du monomère initial, on peut greffer plusieurs couches de polymères de complexes métalliques différents.

Pour cela, dans un premier temps, un complexe est déposé par électropolymérisation sur la surface conductrice ou semi-conductrice. Dans un deuxième temps, un monomère différent est utilisé et électrodéposé sur la couche déjà formée. On obtient ainsi une bicouche à l'électrode. De cette façon, on peut réaliser des multicouches avec des complexes différents et qui présentent des propriétés redox différentes.

L'intérêt de l'obtention de bicouches avec des complexes ayant des propriétés redox différentes est :
- d'obtenir des surfaces rectifiantes, c'est-à-dire que lorsque deux couches sont mises en sandwich entre deux électrodes, le courant ne pourra passer que dans un sens. Ceci pourra permettre de sortir les charges plus facilement d'une cellule photovoltaïque, et
- le stockage de charges : le courant ne pouvant passer que dans un sens, il va être possible de stocker des charges à l'interface des deux couches afin d'obtenir un effet mémoire.

La fonctionnalisation de semi-conducteurs se fait dans des solutions de concentration faible en monomères (10 mmoles à 0,1 mmole) et à température ambiante, ce qui permet de déposer des composés sensibles aux températures élevées.

Les polymères obtenus grâce aux sels de diazonium de l'invention, comme on l'a déjà dit, sont des polymères entièrement conjugués du fait du greffage du radicaux A sur les composés aromatiques comme montré au schéma qui précède. Étant donné que les centres métalliques sont proches et séparés par des espaceurs conjugués, la mobilité des ions à l'intérieur des couches est favorisée, le film formé peut donc servir d'électrolyte solide, en particulier dans des cellules photovoltaïques de type Grätzel.

Enfin, un des avantages majeur des sels de diazonium de l'invention est qu'ils permettent l'électrofonctionnalisation de semi-conducteurs à large bande, tels que TiO₂, SnO₂, ZnO et ZrO₂, ce qui n'avait jamais été réalisé dans l'art antérieur.

Dés lors, l'invention a également pour objet, d'une part, un procédé de formation d'une monocouche de polymère ayant des propriétés redox et d'absorption dans le visible sur une surface conductrice ou semi-conductrice, qui comprend une étape de greffage par voie électrochimique d'un sel de diazonium selon l'invention et une étape de polymérisation de ce sel de diazonium, pour obtenir un film de polymère de l'épaisseur voulue, et, d'autre part, un procédé de formation de multicouches de polymères ayant des propriétés redox et d'absorption dans le visible sur une surface conductrice ou semi-conductrice qui comprend les étapes de : (a) greffage par voie électrochimique d'un sel de diazonium polymérisable selon l'invention, sur ladite surface, (b) polymérisation de ce sel de diazonium pour former un premier film de polymère de l'épaisseur voulue, (c) au moins une étape de greffage, sur le film obtenu à l'étape (a), d'un sel de diazonium polymérisable selon l'invention, le dit sel de diazonium étant identique ou différent du sel de diazonium utilisé à l'étape (a), et (d) polymérisation de ce sel de diazonium, pour former un second film, de l'épaisseur voulue.

Dans un premier mode de mise en oeuvre de ces deux procédés, la surface semi-conductrice est une surface de silicium.

Dans un second mode de mise en oeuvre de ces deux procédés, la surface semi-conductrice est la surface d'un nanotube de carbone.

Dans un troisième mode de mise en oeuvre de ces deux procédés, la surface semi-conductrice est la surface d'une nanoparticule d'oxyde de titane (TiO₂), d'oxyde d'étain (SnO₂), d'oxyde de zinc (ZnO), ou de zircone (ZrO₂).

L'invention a aussi pour objet un substrat qui comporte au moins une surface comportant au moins une couche de polymère obtenu à partir d'un sel de diazonium polymérisable selon l'invention.

L'invention a encore pour objet un dispositif qui comprend au moins un substrat selon l'invention.

Par ailleurs, l'invention a pour objet une cellule photovoltaïque, en particulier de type Grätzel, qui comprend au moins un substrat selon l'invention.

De plus, l'invention a pour objet une cellule de stockage d'informations active redox qui comprend au moins un substrat selon l'invention.

L'invention a aussi pour objet un dispositif semi-conducteur à large bande qui comprend au moins un substrat selon l'invention.

Plus particulièrement, l'invention a pour objet une cellule photovoltaïque de type Grätzel qui comprend un électrolyte solide comprenant au moins un sel de diazonium polymérisable selon l'invention.

Enfin, l'invention a pour objet un électrolyte conducteur solide qui comprend au moins un sel de diazonium selon l'invention.

Outre les dispositions qui précèdent, l'invention comprend encore d'autres dispositions, qui ressortiront de la description qui va suivre, qui se réfère à des exemples de mise en oeuvre des différents objets de l'invention ainsi qu'aux dessins annexés, dans lesquels :
- la figure 1 représente une électrode sur la surface de laquelle les sels de diazonium de l'invention peuvent être greffés de manière covalente;
- la figure 2 représente la courbe de voltampérométrie cyclique obtenue lors de l'électrogreffage des sels de diazonium obtenu à l'exemple 1 sur l'électrode représentée en figure 1;
- la figure 3 représente la courbe de voltampérométrie cyclique de l'électrode de la figure 1 dont la surface a été modifiée par la formation d'un film polymère obtenu à partir d'un sel de diazonium de l'invention et mise en fonctionnement dans un milieu d'analyse exempt de sel de diazonium selon l'invention ;
- la figure 4 représente la courbe de voltampérométrie cyclique de l'électrode modifiée montrée en figure 3, avant et après oxydation du centre métallique ;
- la figure 5 représente une vue de profil d'un dispositif constitué d'une électrode de silicium dopé n avec son contact en chrome-or à la surface de laquelle a été greffé le polymère obtenu à partir des sels de diazonium de l'invention en condition potentiodynamique ;
- la figure 6 représente le photocourant provoqué par l'irradiation par une lumière blanche du dispositif représenté en figure 5,
- la figure 7 représente une vue de profil d'un dispositif constitué d'une électrode de silicium dopé n avec son contact en chrome-or sur laquelle un premier film d'un polymère obtenu à partir d'un sel de diazonium de l'invention comprenant un complexe métallique de ruthénium a été formé, puis un second film d'un polymère obtenu à partir d'un sel de diazonium de l'invention a été formé sur le premier film, et
- la figure 8 représente la courbe de voltampérométrie cyclique obtenue lors de l'électrogreffage des sels de diazonium obtenus à l'exemple 7 sur l'électrode représentée en figure 1.

Il doit être bien entendu, toutefois, que ces exemples sont donnés uniquement à titre d'illustration des objets de l'invention, dont ils ne constituent en aucune manière une limitation.

### Matériaux et méthodes d'analyse

Dans les exemples 1 et 7 de synthèse des sels de diazonium de l'invention, les techniques utilisées pour caractériser les composés obtenus sont la résonance magnétique nucléaire (RMN), l'analyse spectrométrique infrarouge (IR) et UV (UV) et la spectrométrie de masse (MS).

L'analyse chimique élémentaire a été réalisée par le service d'analyse du CNRS de VERNAISON (France).

Les spectres de RMN ont été enregistrés sur un spectromètre Bruker Avance AC 200 MHz (1H ; 200,13 MHz et 13C; 50,32 MHz).

Les déplacements chimiques sont donnés par rapport aux TMS utilisé en tant qu'étalon interne.

Les spectres IR ont été enregistrés avec un spectromètre Perkin Elmer paragon 500.

Les spectres UV ont été enregistrés avec un spectromètre Perkin Elmer Lambda 2.

Les spectres de masse ont été enregistrés avec un spectromètre thermofinnigan équipé d'une source électrospray.

Tous les réactifs et les produits chimiques provenaient de Aldrich ou Acros.

Avant son utilisation, l'acétonitrile a été distillé sur P₂O₅ et le tétrafluoroborate de nitrosium (NOBF₄) a été purifié par trituration dans un mélange 1 :1 d'anhydride acétique et d'acide acétique.

### Exemple 1 : Synthèse du sel de diazonium de formule I-15 :

### [Ru(Bipyridine)₂(Bipyridine-phényl-N₂⁺)] [PF₆⁻]₃

Le composé 4'-(4-aminophényl)-2,2' bipyridine nécessaire à la préparation du sel de diazonium de formule I-15 a été synthétisé en plusieurs étapes selon la littérature.

### Etape 1 : Synthèse de [Ru(bipyridine)₂(bipyridine-phényl-NH₂)] [PF₆]₂

Une solution de 4'-(4-aminophényl)-2,2'bipyridine (200 mg, 0.81 mmol), de Ru(bipyridine)₂Cl₂.2H₂O (392 mg, 1 eq.) dans de l'éthanol (200mL) est dégazée et chauffée à reflux sous atmosphère inerte (N₂) dans le noir pendant 20 heures. La solution est ensuite refroidie et le résidu est chromatographié sur un gel de silice (éluant : CH₃CN/H₂O/solution aqueuse saturée en KNO₃, 40 :4 :1). Les fractions contenant le produit sont rassemblées et un excès de NH₄PF₆ est additionné. L'acétonitrile est ensuite évaporé et le solide rouge obtenu est filtré, lavé par de l'eau et de l'éther éthylique pour donner [Ru(bipyridine)₂(bipyridine-phényl-NH₂)] [PF6]₂ sous forme de solide rouge (540 mg, rendement : 70%).

¹H NMR (DMSO-d₆) : δ = 9,10 (d, J = 8,2 Hz, 1H) ; 8,96 (s, 1H), 8,86-8,82 (m, 4H) ; 8,25-8,10 (m, 5H) ; 7,88-7,70 (m, 8H) ; 7,60-7,48 (m, 6H) ; 6,70 (d, J=8,6 Hz, 2H) ; 5,85 (s, 2H).

¹³C NMR (DMSO-d₆):δ = 157,03; 156,66; 156,63; 156,60; 156,56; 156,48; 151,73; 151,22; 151,15; 151,09; 150,33; 148,56; 137,77; 128,42; 127,86; 127,67; 124,58; 124,44; 122,23; 120,80; 119,16; 118,09; 113,95.

IR ν cm⁻¹: 3393, 3097, 1599, 1467, 1442, 1189, 1035, 828, 761.

UV/Vis (ACN) λ = 288 nm (log ε = 5,00), λ = 352 nm (log ε = 4,44), λ = 457 nm (log ε = 4,40).

MS-ESI: m/z [M - PF_{6]} + 806,0, [M - 2 PF6-]2+ 330,6. Analyse élémentaire calculée en pourcentage pour C₃₆H₂₉N₇RuP₂F₁₂: C 45,42, H 3,07, N 10,31. Trouvée : C 45,71, H 3,23, N 10,37.

### Etape 2 : [Ru(bipyridine)₂(bipyridine-phényl-N₂⁺)][PF₆]₃,

Sous atmosphère inerte, une solution de composé obtenu à l'étape 1 [Ru(bipyridine)₂(bipyridine-phényl-NH₂)] [PF₆]₂, (250 mg, 0,26 mmol) dans 2 mL d'acétonitrile distillé est dégazée et ajoutée à une solution de NOBF₄ (37 mg, 1,2 eq.) dans 2 mL d'acétonitrile distillée sous argon à -40°C. Le mélange est agité à cette température pendant 30 minutes et 50 mL d'éther éthylique sont ajoutés au mélange. Le précipité formé est filtré, lavé plusieurs fois par de l'éther éthylique. Le composé obtenu est un solide marron (280 mg, rendement : 97%).

¹H NMR (DMSO-d6) : δ = 9,27 (s, 1H) ; 9,10 (d, J = 8,0 Hz, 1 H) ; 8,90-8,80 (m, 6H) ; 8,54 (d, J = 8,6 Hz, 2H) ; 8,30-8,10 (m, 5H) ; 7,98-7,85 (m, 2H) ; 7,85-7,70 (m, 5H) ; 7,62-7,45 (m, 5H).

IR ν cm⁻¹: 3114,2275 (N≡N), 1587, 1452, 1394, 1189, 1035, 837, 764.

UV/Vis (ACN) λ = 287 nm (log ε = 4,87), λ = 455 nm (log ε = 4,14).

### Exemple 2: Electrogreffage du sel de diazonium obtenu à l'exemple 1 sur une électrode de semi-conducteur à bande étroite (silicium dopé n)

Un montage électrochimique classique, à trois électrodes : électrode de travail, électrode de référence, et contre-électrode, est utilisé.

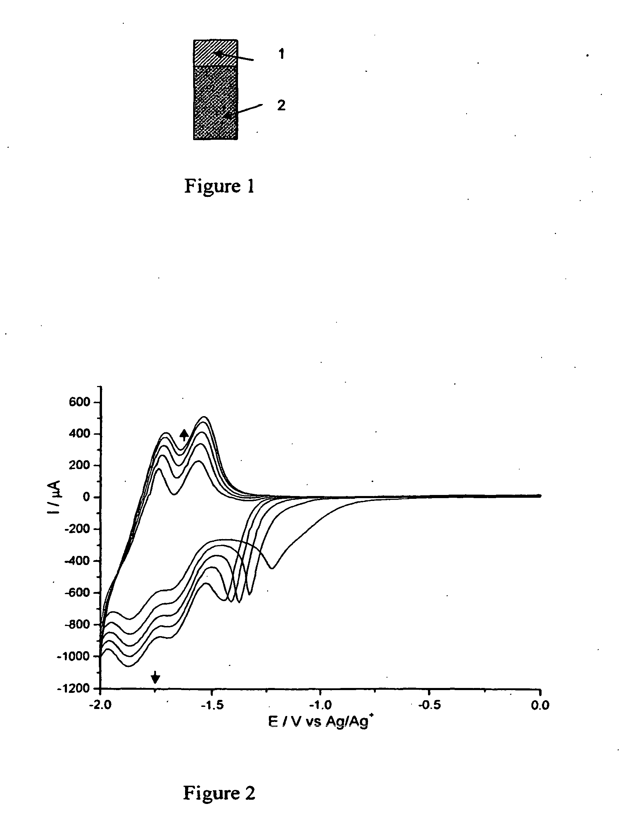

La figure 1 représente l'électrode sur la surface de laquelle le sel de diazonium obtenu à l'exemple 1 va être greffé de façon concovalente. Cette électrode a un plot chrome-or, noté 1 en figure 1 qui assure une bonne conduction avec le silicium dopé n, noté 2 en figure 1, et permet de prendre un point de contact afin de réaliser l'électrogreffage.

Avant l'électrogreffage, les électrodes en silicium sont trempées une minute dans une solution à 1% d'acide fluoridrique (HF), puis dans de l'eau, et enfin dans de l'isopropanol afin d'éliminer la couche d'oxyde natif et d'obtenir une surface de silicium hydrogénée.

Puis l'électrode de travail est plongée dans une solution d'acétonitrile dégazée comprenant un électrolyte (LiClO4, NBu₄PF₆ (0,1 M)) et le sel de diazonium obtenu à l'exemple 1. L'électrogreffage a ensuite été réalisé dans des conditions potentiodynamiques ou potentiostatiques, à température ambiante.

La figure 2 représente la courbe de voltampérométrie cyclique obtenue lors de l'électrogreffage du sel de diazonium obtenu à l'exemple 1 sur une électrode de silicium fortement dopé n (8 x10⁻³ / 2 x 10⁻² Ω.cm) lorsque l'on effectue un balayage dynamique du potentiel durant 5 cycles entre 0 et -2V en fonction de Ag/Ag+.

Comme on le voit en figure 2, durant le premier balayage, le voltamogramme présente une vague irréversible vers -1,15 V, ce qui correspond à la réduction du sel de diazonium en radical qui réagit avec la surface de silicium hydrogénée pour former des liaisons covalentes, et deux vagues de réduction réversibles vers -1,5 V et -1,75 V. Ces deux vagues de réduction réversibles sont liées à la réduction des ligands bipyridine, terpyridine ou phénanthroline.

L'augmentation d'intensité du courant des vagues de réduction des ligands du complexe en cyclant entre 0 et -2 V est caractéristique d'une modification de la surface de l'électrode.

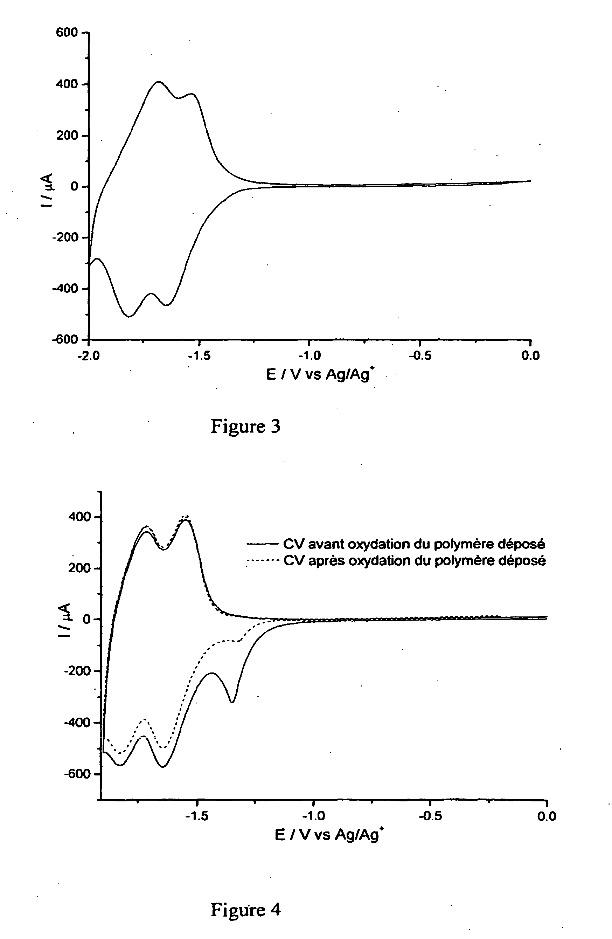

La figure 3 représente la courbe de voltampérométrie cyclique réalisée sur l'électrode modifiée, c'est à dire avec un film de du polymère obtenu à partir du sel de diazonium de l'exemple 1. Dans ce cas, le milieu d'analyse était exempt de sel de diazonium selon l'invention.

Cette courbe montre clairement le dépôt de complexe de ruthénium à la surface de l'électrode de silicium.

En effet, après lavage de l'électrode par des solvants où le complexe initial est soluble, les courbes de voltampérométrie présentent les deux vagues de réduction réversibles caractéristiques du complexe avec des potentiels identiques au complexe initial.

Ceci montre que les films de polymère greffés sur l'électrode de silicium ont des propriétés redox qui permettent non seulement d'acheminer des électrons à la surface du film déjà déposé pour propager la polymérisation et ainsi obtenir des films de polymères d'épaisseur pouvant aller jusqu'à plusieurs centaines de nanomètres, mais aussi d'obtenir un film organique conducteur à la surface de l'électrode, ce qui permet de déposer, si on le souhaite, une seconde couche de polymère d'un complexe métallique différent sur le film déjà formé.

### Exemple 3 : Electrogreffage du sel de diazonium obtenu à l'exemple 1 sur un semi-conducteur à large bande (ZnO).

On a procédé comme à l'exemple 2 ci-dessus mais en utilisant des électrodes de ZnO.

Les courbes de voltampérométrie cyclique obtenues sont identiques à celles obtenues à l'exemple 2.

Cet exemple montre qu'il est possible, grâce aux sels de diazonium de l'invention, d'électrofonctionnaliser des semi-conducteurs à bande large, ce qui n'avait jamais été réalisé dans l'art antérieur.

### Exemple 4 : Capture de charges dans les polymères obtenus à partir du sel de diazonium de l'exemple 1

La figure 4 met en évidence la capture de charges dans le polymère électrogreffé obtenu à partir du sel de diazonium de l'exemple 1 lorsqu'on a oxydé le centre métallique du complexe greffé à l'électrode, que cette électrode soit une électrode de silicium dopé n ou une électrode ZnO.

Sur la figure 4, le voltamogramme en trait plein correspond à la réponse d'un film obtenu par formation du sel de diazonium obtenu à l'exemple 1 en mode potentiostatique, après oxydation du centre métallique et le voltamogramme en trait pointillé correspond à la réponse d'un film obtenu à partir du sel de diazonium obtenu à l'exemple 1 en mode potentiostatique, avant oxydation du centre métallique.

Le film présente les deux vagues de réduction réversibles des ligands. Lorsque l'électrode est ensuite portée à un potentiel de 1,2V en fonction de Ag/Ag+, la réponse électrochimique du polymère déposé à l'électrode change et présente une vague supplémentaire irréversible vers -1,3V. Ceci correspond à la réduction des charges capturées lors de l'oxydation du centre métallique.

Ceci démontre que des charges se sont stockées dans ce type de polymère et que, par conséquent, ce type de polymère est utilisable dans le stockage d'informations.

### Exemple 5 : Utilisation du polymère obtenu à partir du sel de diazonium obtenu à l'exemple 1 comme électrolyte solide.

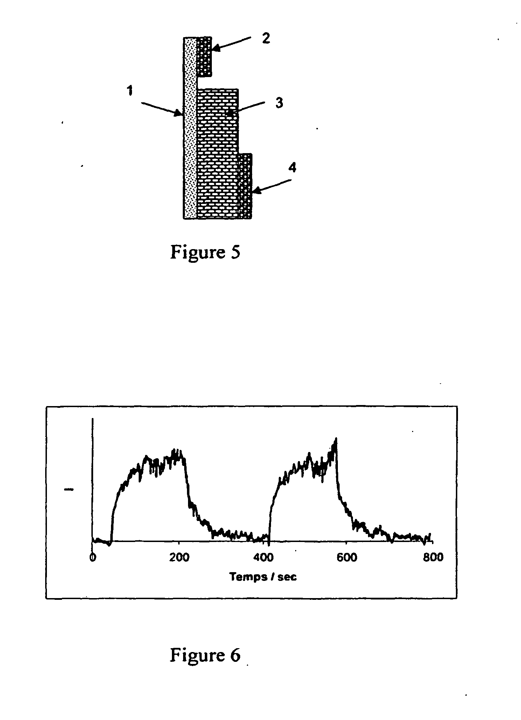

La figure 5 représente une vue de profil d'un dispositif constitué d'une électrode de silicium dopé n (14/22 Ω.cm), notée 1 en figure 5, avec son contact en chrome-or, noté 2 en figure 5, sur laquelle a été formé le polymère obtenu à partir du sel de diazonium synthétisé à l'exemple 1, noté 3 en figure 5, en condition potentiodynamique (épaisseur de 40 à 100 nm).

Une électrode métallique en or, notée 4 en figure 5, a ensuite été déposée directement sur le film 3 par évaporation sous vide.

L'irradiation par une lumière blanche (Puissance de 100Mw/cm²) provoque un courant qui est dû à l'absorption de la lumière par le semi-conducteur en silicium.

La figure 6 représente le photocourant ainsi provoqué.

L'absorption de la lumière par le semi-conducteur en silicium génère des charges à l'intérieur du semi-conducteur qui peuvent être extraites grâce aux transports de trous dans le polymère redox formé préalablement.

Dans cet exemple, le polymère sert d'électrolyte solide et permet d'éviter la décomposition photo-anodique généralement obtenue lorsqu'on utilise un électrolyte liquide.

### Exemple 6 : Formation de différentes couches de complexes métalliques sur une surface de silicium

Grâce à la spécificité des sels de diazonium de l'invention, il est possible de greffer plusieurs couches de complexes métalliques sur une électrode.

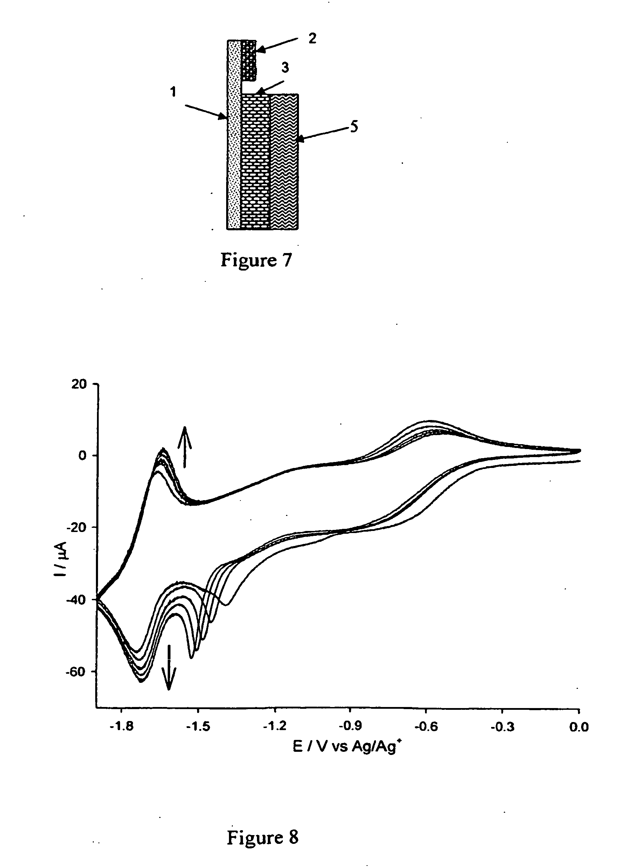

La figure 7 montre une vue de profil d'un dispositif constitué d'une électrode de silicium dopé n, notée 1 en figure 7, avec son contact métallique en chrome-or, noté 2 en figure 7, sur laquelle a été formée une première couche du sel de diazonium obtenu à l'exemple 1, noté 3 en figure 7.

Sur cette couche 3, il est alors possible de recommencer l'électrodépot d'un autre complexe métallique, pour obtenir une couche, notée 5 en figure 7.

On peut fabriquer ainsi des électrodes sur lesquelles il y a plusieurs couches de complexes métalliques. Ces couches sont alors capables de stocker des charges pour la réalisation de mémoires.

### Exemple 7 : Synthèse du sel de diazonium de formule I-16 :

### [Ir(phénylpyridine)₂(Bipyridine-phényl-N₂⁺)] [PF₆]₂

### Etape 1 : Synthèse de [Ir(phénylpyridine)₂(Bipyridine-phényl-N₂⁺)]PF₆]₂

Une solution de 4'-(4-aminophényl)-2,2'bipyridine (100 mg, 0.4 mmol), de tétrakis(2-phénylpyridine-*C₂-,N*')(µ-dichloro)diiridium (215mg, 0.5 eq.) (Précurseur métallique qui a été synthétisé selon le mode opératoire décrit par Watt et All, J. Am. Chem. Soc. 1984, 106, 6647) dans un mélange 1/1 méthanol/dichlorométhane (30 mL) est chauffée à reflux sous atmosphène inerte (Ar) pendant 8 heures Après retour à température ambiante, 2mL d'une solution saturée de KPF₆ sont additionnés et les solvants sont ensuite évaporés au rotavapeur. Le solide jaune obtenu est alors trituré dans de l'eau puis filtré, lavé plusieurs fois par de l'eau puis de l'éther éthylique. Le solide est ensuite dissous dans l'acétonitrile et chromatographié sur un gel de silice (éluant : CH₃CN/H₂O/ solution aqueuse saturée en KNO₃ 18:2:1). Les fractions contenant le produit sont rassemblées et un excès de NH₄PF₆ est additionné. L'acétonitrile est ensuite évaporé et le solide jaune obtenu est filtré, lavé par de l'eau et de l'éther éthylique pour donner [Ir(Phénylpyridine)₂(bipyridine-phényl-NH₂)][PF₆] sous forme de poudre jaune (220mg, 62% ).

¹H NMR (Acétone-d₆) : δ = 9,05 (d, J = 8,3 Hz, 1H) ; 8,95 (d, J= 1,9 Hz, 1H) ; 8,36-8,18 (m, 3H) ; 8,08 (d, J =5,5 Hz, 1H) ; 8,00-7,73 (m, 10H) ; 7,67 (t, J = 6,3 Hz, 1H) ; 7,16 (m, 2H) ; 7,03 (t, J = 7,6 Hz, 2H) ; 6,90 (d, J = 7,3 Hz, 2H) ; 6,82 (d, J = 8,6 Hz, 2H) ; 6,38 (d, J = 7,1 Hz, 2H) ; 5,44 (s, 2H).

IR σ cm⁻¹: 3393, 3097, 1599,

UV/Vis (ACN)λ = 377 nm, λ = 337 nm.

MS-ESI: m/z [M - PF_{6]} ⁺748.

Analyse élémentaire calculée en pourcentage pour C₃₈H₂₉N₅lrPF₆:
C 51 ,12 ; H 3,27 ; N 7,84. Trouvée : C 50,96 ; H 3,17; N 7,58.

### Etape 2: Synthèse du sel de diazonium [Ir(Phénylpyridine)₂(bipyridine-phényl-NH₂)][PF₆]

Sous atmosphère inerte, une solution de [Ir(Phénylpyridine)₂(bipyridine-phényl-N₂⁺)][PF₆] (100 mg ; 0,11 mmol) dans 2 mL d'acétonitrile distillé est dégazée et ajoutée à une solution de NOBF₄ (16 mg, 1,2 eq.) dans 2 mL d'acétonitrile distillée sous argon à -40°C. Le mélange est agité à cette température pendant 30 minutes et 50 mL d'éther éthylique sont ajoutés. Le précipité formé est filtré, lavé plusieurs fois par de l'éther éthylique. Le composé obtenu est un solide jaune marron (107 mg, 98%).

¹H NMR (DMSO-d6) : δ = 9,31 (s, 1H) ; 9,15 (d, J = 8,4 Hz, 1H) ; 8,46 (d, J = 8,6 Hz, 2H) ; 8,54 (d, J = 8,6 Hz, 2H) ; 8.45-8,22 (m, 3H) ; 8,17 (d, J = 4,9 Hz, 1H) ; 8,07-7,86 (m, 6H) ; 7,80-7,60 (m, 3H) ; 7,25-6,85 (m, 6H) ; 6,21 (t, J = 6,0 Hz, 2H).

IR σ cm⁻¹: 2276 (N = N),

### Etape 3 : Greffage et polymérisation électrochimique du sel de diazonium [[Ir(Phénylpyridine)₂(bipyridine-phényl-NH₂)][PF₆] sur une électrode de platine.

Le montage utilisé est identique à celui utilisé aux exemples 2 et 3 pour l'électrodéposition du comlexe de ruthénium. Dans cet exemple, le complexe est greffé et polymérisé sur une surface métallique qui est le platine.

La figure 8 représente la courbe de voltampérométrie obtenue lors du greffage du sel de diazonium du complexe d'iridium obtenu ci-dessus sur une électrode de platine lorsqu'on effectue un balayage dynamique du potentiel durant 5 cycles entre 0 et -1,9V en fonction de Ag/Ag⁺. La figure 8 montre une vague irréversible vers -1,39V, qui correspond à la formation d'un radical cation du sel de diazonium et une vague de réduction réversible à -1.7V correspondant à la réduction du complexe. L'augmentation d'intensité du courant lors du cyclage entre 0 et -1,9V montre clairement la formation d'un dépôt du complexe d'iridium sur la surface de l'électrode.

Bien que les exemples ci-dessus aient montré les avantages des sels de diazonium de l'invention pour le dépôt électrochimique de différentes couches de complexes métalliques sur une surface de silicium, d'oxyde de zinc ou de platine, l'invention n'est nullement limitée à l'électrofonctionnalisation de surfaces de silicium de ZnO ou de platine.

En effet, l'électrofonctionnalisation de surfaces de TiO₂, de SnO₂, de ZrO₂, de nanotubes de carbone SWNT, MWNT, de nanoparticules, ainsi que de toutes surfaces conductrices telles que des surfaces d'or, d'iridium, de fer, d'aluminium, etc, peut être effectuée de la même façon.

De même, bien que l'invention ait été décrite dans les exemples qui précèdent comme ayant des applications dans les domaines de la conversion d'énergie et du stockage d'informations, les sels de diazonium de l'invention pourront permettre de réaliser d'autres dispositifs dans lesquels l'électrofonctionnalisation d'une surface conductrice ou semi-conductrice est intéressante.

Egalement, bien que les exemples fassent référence à la formation de bicouches de composés métalliques différents sur un substrat, il apparaîtra clairement à l'homme de l'art qu'autant de couches différentes ou identiques pourront être déposées sur au moins une surface conductrice ou semi-conductrice d'un substrat.

## Revendications

1. Sels de diazonium polymérisables **caractérisés en** en ce qu'ils ont des propriétés redox et d'absorption dans le visible et en ce qu'ils ont la formule générale (I) suivante :
[X^{x+} LₙD_{d} Eₘ (N₂⁺)ₚ] [(B⁻)ₚ₊ₓ] Formule I
dans laquelle :
- X est un métal de transition choisi parmi le ruthénium (Ru), l'osmium (Os), le fer (Fe), le cobalt, (Co), et l'iridium (Ir),
- x est un entier valant de 1 à 5 inclus,
- L est un ligand choisi parmi les groupements pyridine, bipyridine, terpyridine, phénanthroline, phénylpyridine, et les mélanges de ceux-ci,
- n est un entier valant de 1 à 5, inclus
- D est un composé espaceur alkyle en C₁-C₅, saturé ou insaturé,
- d = 0 ou 1,
- E est un composé espaceur aromatique ou polyaromatique, pouvant comporter un ou plusieurs hétéroatomes, choisi parmi un groupement benzothiophène, benzofurane, indole, indoline, carbazole, déhydroquinoléine, chromone, julodinine, thiadiazole, triazole, isoxasole, oxazole, thiazole, isothiazole, imidazole, pyrazole, thiazine, triazine, pyrazine, pyridazine, pyrimidine, diazépine, oxazépine, benzotriazole, benzoaxazole, imidazole, benzimidazole, morpholine, pipéridine, pipérazine, azétidine, pyrrolidine, aziridine, un groupement phényle, biphényle, thiophène, bithiophène, furane, bifurane, pyridine, bipyridine, terpydidine, fluorène, fluorénone ou les mélanges de ceux-ci, et
- B est un contre-ion,
- m est un entier valant de 0 à 5 inclus,
- p est un entier.

2. Sels de diazonium selon la revendication 1 **caractérisés en ce que** B est un groupement chlorate, fosylate, sulfonate, un polymère anionique, PF₆ ou BF₄.

3. Sels de diazonium selon la revendication 1 **caractérisés en ce que** B est un groupement PF₆ ou BF₄.

4. Sels de diazonium selon l'une quelconque des revendications précédentes, **caractérisés en ce qu'**ils ont l'une des formules générales I-2 à I-7 suivantes : 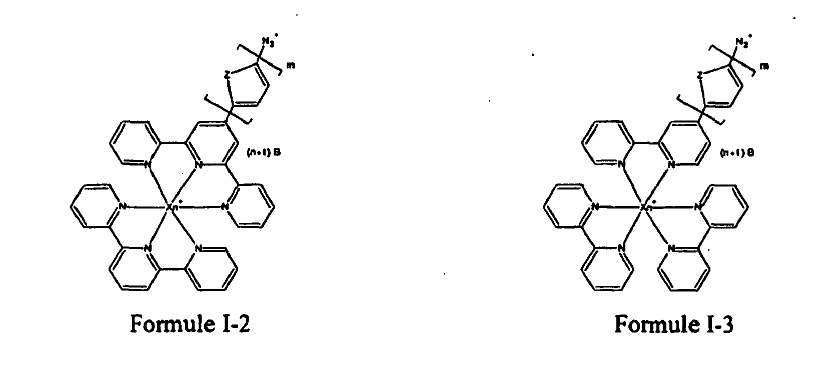 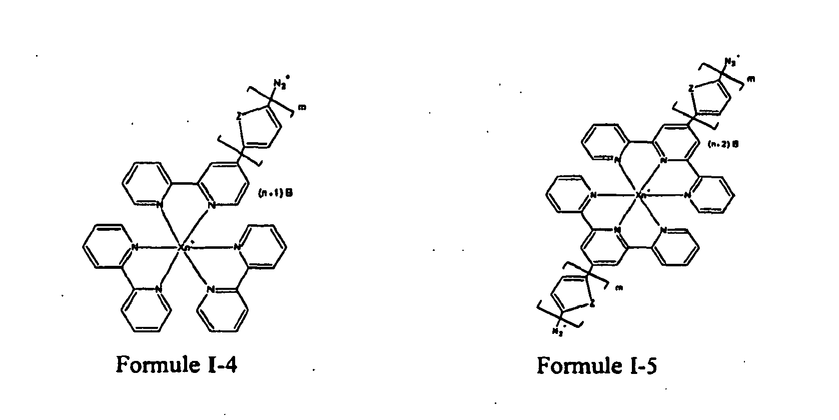 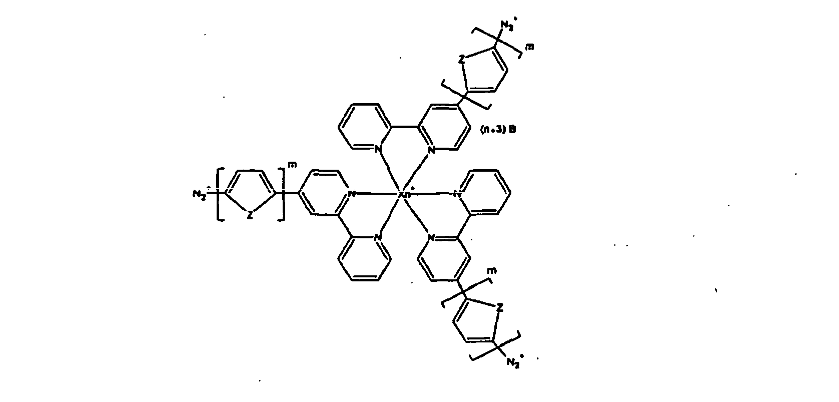 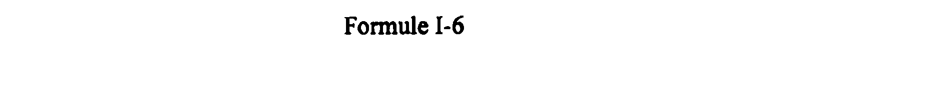 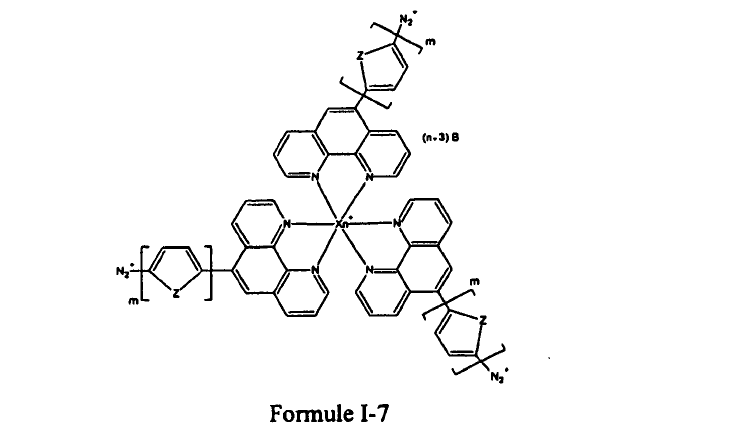 dans lesquelles :
- X est choisi parmi le ruthénium (Ru), l'osmium (Os), le fer (Fe), le cobalt (Co), et l'iridium (Ir),
- Z est CH=CH, S, O, CH=N, N-H, N = N, et
- m est un entier valant de 0 à 5 inclus, et
- B est BF₄ ou PF₆.

5. Sels de diazonium selon l'une quelconque des revendications 1 à 3, **caractérisés en ce qu'**ils ont l'une des formules générales I-8 à I-12 suivantes : 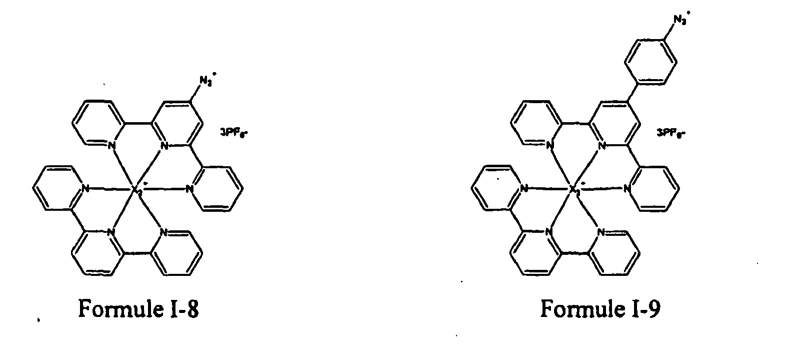 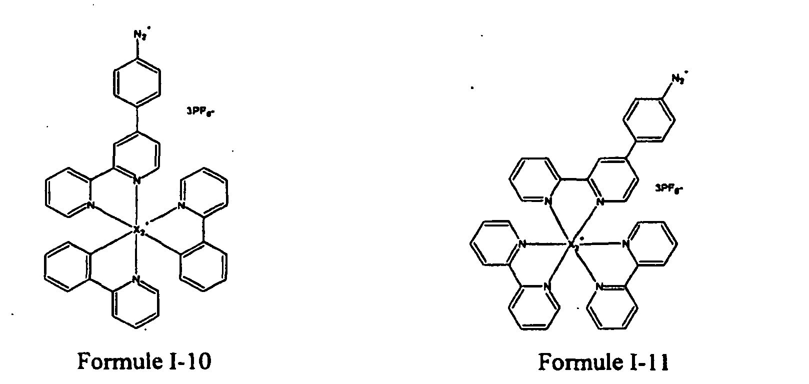 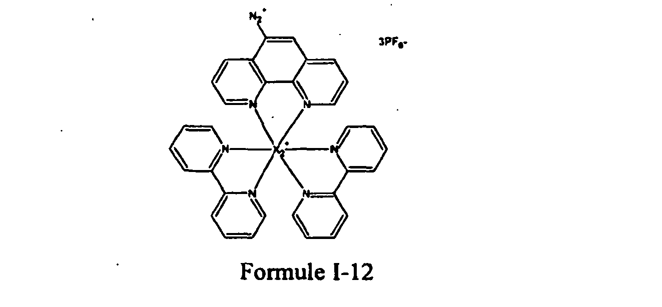 dans lesquelles X est choisi parmi le ruthénium (Ru) et l'osmium (Os) et B est PF₆.

6. Sels de diazonium selon l'une quelconque des revendications 1 à 3, **caractérisés en ce qu'**ils ont l'une des formules générales I-13 à I-14 suivantes : 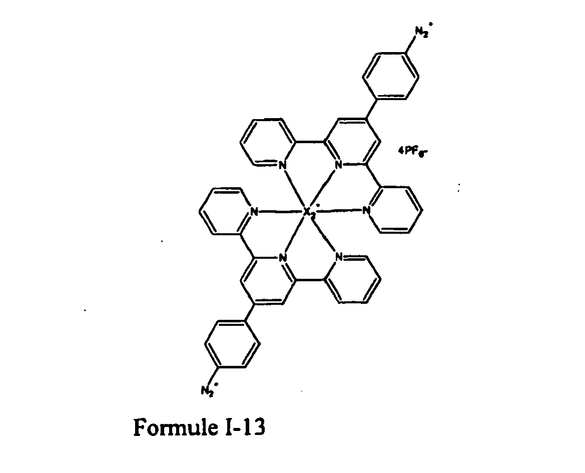 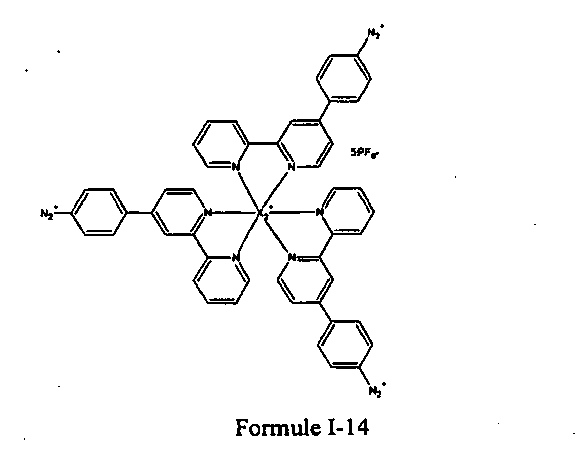 dans lesquelles X est choisi parmi le fer (Fe), le ruthénium (Ru) et l'osmium (Os) et B est PF₆.

7. Sel de diazonium selon l'une quelconque des revendications 1 à 3, **caractérisé en ce que** :
- X est le ruthénium (Ru),
- L est un groupement bipyridine,
- n=2
- E un groupement bipyridine- phényle,
- m = 1,
- p= 1,
- B = PF₆,
de formule générale (I-15) suivante :
[Ru (bipyridine)₂ (bipyridine-phényl-N₂⁺)] [PF₆]₃ Formule I-15.

8. Sel de diazonium selon l'une quelconque des revendications 1 à 3, **caractérisé en ce que** :
- X est le l'Iridium (Ir),
- L est un groupement phénylpyridine,
- n=2
- E un groupement bipyridine- phényle,
- m = 1,
- p= 1,
- B = PF₆,
de formule générale (I-16) suivante :
[Ir(phénylpyridine)₂(Bipypyridine-phényl-N₂⁺)][PF₆]₂ Formule I-16

9. Procédé de synthèse de sels de diazonium selon l'une quelconque des revendications précédentes **caractérisé en ce qu'**il comprend les étapes suivantes :
- (a) synthèse du complexe métallique voulu de formule XLₙ où tous les ligands L ont au moins une fonction amine aromatique et peuvent être identiques ou différents, et
- (b) transformation des fonctions amines en N₂⁺ en utilisant NOBF₄.

10. Procédé de formation d'une monocouche de polymère ayant des propriétés redox et d'absorption dans le visible sur une surface conductrice ou semi-conductrice, **caractérisé en ce qu'**il comprend une étape de greffage par voie électrochimique d'un sel de diazonium selon l'une quelconque des revendications 1 à 8 et une étape de polymérisation de ce sel de diazonium, pour obtenir un film de polymère de l'épaisseur voulue.

11. Procédé de formation de multicouches de polymères ayant des propriétés redox et d'absorption dans le visible, sur une surface conductrice ou semi-conductrice, **caractérisé en qu'**il comprend les étapes suivantes :
(a) greffage par voie électrochimique d'un sel de diazonium polymérisable selon l'une quelconque des revendications 1 à 8, sur ladite surface,
(b) polymérisation de ce sel de diazonium pour former un premier film de polymère de l'épaisseur voulue,
(c) au moins une étape de greffage, sur le film obtenu à l'étape (a), d'un sel de diazonium polymérisable selon l'une quelconque des revendications 1 à 8, le dit sel de diazonium étant identique ou différent du sel de diazonium utilisé à l'étape (a), et
(d) polymérisation de ce sel de diazonium, pour former un second film, de l'épaisseur voulue.

12. Procédé selon la revendication 10 ou 11 **caractérisé en que** la surface semi-conductrice est une surface de silicium ou de platine.

13. Procédé selon la revendication 10 ou 11 **caractérisé en ce que** la surface semi-conductrice est la surface d'un nanotube de carbone.

14. Procédé selon la revendication 10 ou 11 **caractérisé en ce que** la surface semi-conductrice est la surface d'une nanoparticule d'oxyde de titane (TiO₂), d'oxyde d'étain (SnO₂), d'oxyde de zinc (ZnO), ou de zircone (ZrO₂).

15. Substrat **caractérisé en ce qu'**il comporte au moins une surface comportant au moins une couche de polymère obtenu à partir d'un sel de diazonium polymérisable selon l'une quelconque des revendications 1 à 8.

16. Dispositif **caractérisé en ce qu'**il comprend au moins un substrat selon la revendication 15.

17. Cellule photovoltaïque, en particulier de type Grätzel, **caractérisée en ce qu'**elle comprend au moins un substrat selon la revendication 15.

18. Cellule de stockage d'informations active redox **caractérisée en ce qu'**elle comprend au moins un substrat selon la revendication 15.

19. Dispositif semi-conducteur à large bande **caractérisé en ce qu'**il comprend au moins un substrat selon la revendication 15.

20. Cellule photovoltaïque de type Grätzel **caractérisée en ce qu'**elle comprend un électrolyte solide comprenant au moins un sel de diazonium polymérisable selon l'une quelconque des revendications 1 à 8.

21. Electrolyte conducteur solide **caractérisé en ce qu'**il comprend au moins un sel de diazonium selon l'une quelconque des revendications 1 à 8.

## Claims

1. Polymerisable diazonium salts, **characterised in that** they have redox and absorption properties in visible light and **in that** they have the following general formula (I) :
[X^{x+} LₙD_{d} Eₘ (N₂⁺)ₚ] [(B⁻)ₚ₊ₓ] formula I
wherein :
- X is a transition metal selected from among ruthenium (Ru), osmium (Os), iron (Fe), cobalt (Co), and iridium (Ir),
- x is an integer with a value of from 1 to 5 inclusive,
- L is is ligand selected from among the pyridine, bipyridine, terpyridine, phenanthroline and phenylpyridine groups, and mixtures thereof,
- n is an integer with a value of from 1 to 5 inclusive,
- D is a saturated or unsaturated C₁-C₅-alkyl spacer compound,
- d = 0 or 1,
- E is an aromatic or polyaromatic spacer compound which may comprise one or more heteroatoms, selected from among a benzothiophene, benzofuran, indole, indoline, carbazole, dehydroquinoline, chromone, julodinine, thiadiazole, triazole, isoxasole, oxazole, thiazole, isothiazole, imidazole, pyrazole, thiazine, triazine, pyrazine, pyridazine, pyrimidine, diazepine, oxazepine, benzotriazole, benzoxazole, imidazole, benzimidazole, morpholine, piperidine, piperazine, azetidine, pyrrolidine or aziridine group, a phenyl, biphenyl, thiophene, bithiophene, furan, bifuran, pyridine, bipyridine, terpydidine, fluorene or fluorenone group or mixtures thereof, and
- B is a counter-ion,
- m is an integer with a value of from 0 to 5 inclusive,
- p is an integer.

2. Diazonium salts according to claim 1 **characterised in that** B is a chlorate, fosylate or sulphonate group, an anionic polymer, PF₆ or BF₄,

3. Diazonium salts according to claim 1 **characterised in that** B is a PF₆ or BF₄ group.

4. Diazonium salts according to any one of the preceding claims, **characterised in that** they have one of the following general formulae I-2 to I-7: 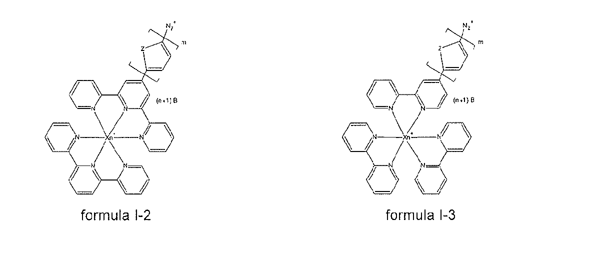 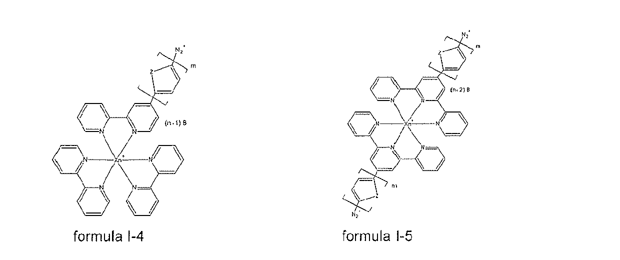 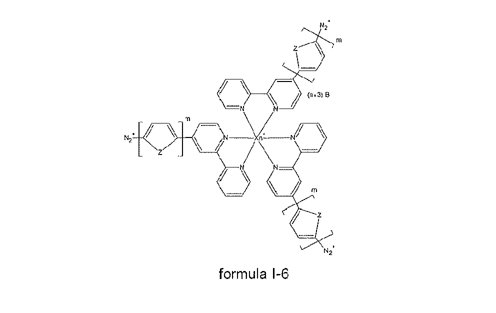 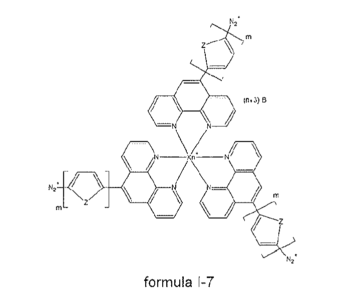 wherein :
- X is selected from among ruthenium (Ru), osmium (Os), iron (Fe), cobalt (Co), and iridium (Ir),
- Z is CH=CH, S, O, CH=N, N-H, N = N, and
- m is an integer with a value of from 0 to 5 inclusive, and
- B is BF₄ or PF₆.

5. Diazonium salts according to any one of claims 1 to 3, **characterised in that** they have one of the following general formulae I-8 to I-12: 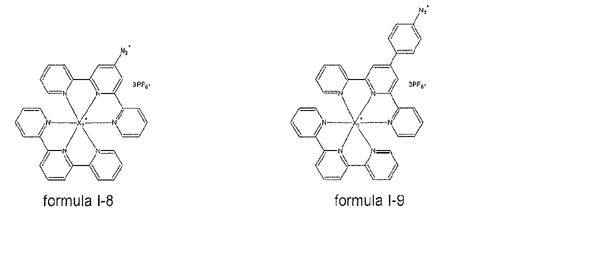 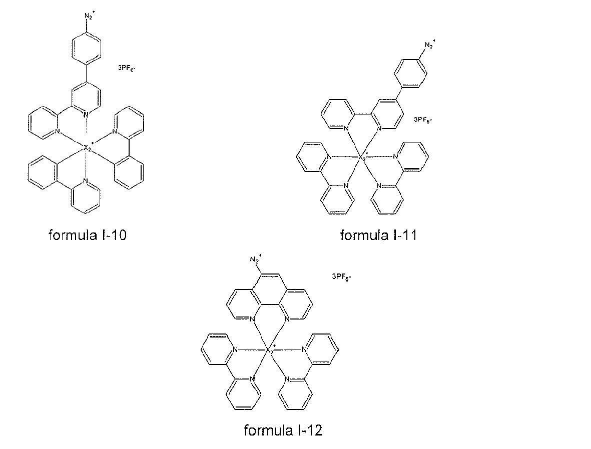 wherein X is selected from among ruthenium (Ru) and osmium (Os) and B is PF₆,

6. Diazonium salts according to any one of claims 1 to 3, **characterised in that** they have one of the following general formulae I-13 to I-14: 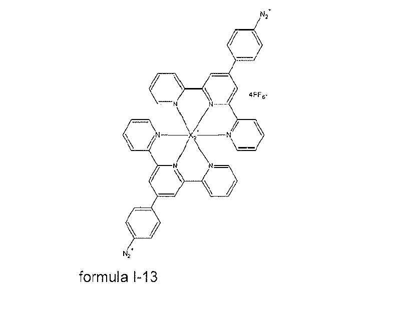 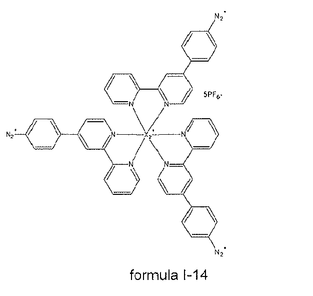 wherein X is selected from among iron (Fe), ruthenium (Ru) and osmium (Os) and B is PF₆.

7. Diazonium salt according to any one of clams 1 to 3, **characterised in that**:
- X is ruthenium (Ru),
- L is a bipyridine group,
- n = 2
- E is a bipyridine-phenyl group,
- m = 1,
- p = 1,
- B = PF₆,
of the following general formula (I-15):
[Ru (bipyridine)₂ (bipyridine-phenyl-N₂⁺)] [PF₆]₃ Formula I-15.

8. Diazonium salt according to any one of claims 1 to 3, **characterised in that**:
- X is iridium (Ir),
- L is a phenylpyridine group,
- n = 2
- E is a bipyridine-phenyl group,
- m = 1,
- p = 1,
- B = PF₆,
of the following general formula (I-16):
[Ir(phenylpyridine)₂(Bipypyridine-phenyl-N₂⁺)][PF₆]₂ Formula I-16

9. Process for synthesising diazonium salts according to any one of the preceding claims, **characterised in that** it comprises the following steps :
- (a) synthesising the desired metal complex of formula XLₙ wherein all the ligands L have at least one aromatic amine function and may be identical or different, and
- (b) converting the amine functions into N₂⁺ using NOBF₄.

10. Process for forming a polymer monolayer having redox and absorption properties in visible light on a conductive or semi-conductive surface, **characterised in that** it comprises a step of electrochemically grafting a diazonium salt according to any one of claims 1 to 8 and a step of polymerising this diazonium salt, to obtain a polymer film of the desired thickness.

11. Process for forming polymer multilayers having redox and absorption properties in visible light, on a conductive or semi-conductive surface, **characterised in that** it comprises the following steps :
(a) electrochemically grafting a polymerisable diazonium salt according to any one of claims 1 to 8 onto said surface,
(b) polymerising this diazonium salt to form a first polymer film of the desired thickness,
(c) at least one step of grafting a polymerisable diazonium salt according to any one of claims 1 to 8 onto the film obtained in step (a), said diazonium salt being identical to or different from the diazonium salt used in step (a), and
(d) polymerising this diazonium salt, to form a second film of the desired thickness.

12. Process according to claim 10 or 11, **characterised in that** the semi-conductive surface is a silicon or platinum surface.

13. Process according to claim 10 or 11, **characterised in that** the semi-conductive surface is the surface of a carbon nanotube.

14. Process according to claim 10 or 11, **characterised in that** the semi-conductive surface is the surface of a nanoparticle of an oxide of titanium (TiO₂), an oxide of tin (SnO₂), an oxide of zinc (ZnO) or an oxide of zirconium (ZrO₂).

15. Substrate, **characterised in that** it comprises at least one surface comprising at least one polymer layer obtained from a polymerisable diazonium salt according to any one of claims 1 a 8.

16. Apparatus, **characterised in that** it comprises at least one substrate according to claim 15.

17. Photovoltaic cell, particularly of the Grätzel type, **characterised in that** it comprises at least one substrate according to claim 15.

18. Redox-active information storage cell, **characterised in that** it comprises at least one substrate according to claim 15.

19. Broadband semi-conductor apparatus, **characterised in that** it comprises at least one substrate according to claim 15.

20. Grätzel type photovoltaic cell, **characterised in that** it comprises a solid electrolyte comprising at least one polymerisable diazonium salt according to any one of claims 1 to 8.

21. Solid conductive electrolyte, **characterised in that** it comprises at least one diazonium salt according to any one of claims 1 to 8.

## Patentansprüche

1. Polymerisierbare Diazoniumsalze, **dadurch gekennzeichnet, dass** sie Redoxeigenschaften und im sichtbaren Bereich Absorptionseigenschaften besitzen, sowie dadurch, dass sie die folgende allgemeine Formel (I) haben:
[X^{x+} LₙD_{d}Eₘ (N₂⁺)ₚ] [(B⁻)ₚ₊ₓ] Formel I
in der:
- X für ein Übergangsmetall steht, das unter Ruthenium (Ru), Osmium (Os), Eisen (Fe), Cobalt (Co) und Iridium (Ir) ausgewählt ist,
- x ein ganzzahliger Wert von einschließlich 1 bis 5 ist,
- L für einen Liganden steht, der unter den Pyridin-, Bipyridin-, Terpyridin-, Phenanthrolin-, Phenylpyridingruppen und unter den Mischungen von diesen ausgewählt ist,
- n ein ganzzahligerWert von einschließlich 1 bis 5 ist,
- D für eine gesättigte oder ungesättigte C₁-C₅-Alkyl-Spacerverbindung steht,
- d = 0 oder 1,
- E für eine aromatische oder polyaromatische Spacerverbindung steht, die ein oder mehrere Heteroatome aufweisen kann und unter einer Benzothiophen-, Benzofuran-, Indol-, Indolin-, Carbazol-, Dehydrochinolein-, Chromon-, Julodinin-, Thiadiazol-, Triazol-, Isoxasol-, Oxazol-, Thiazol-, Isothiazol-, Imidazol-, Pyrazol-, Thiazin-, Triazin-, Pyrazin-, Pyridazin-, Pyrimidin-, Diazepin-, Oxazepin-, Benzotriazol-, Benzoaxazol-, Imidazol-, Benzimidazol-, Morpholin-, Piperidin-, Piperazin-, Azetidin-, Pyrrolidin-, Aziridingruppe, einer Phenyl-, Biphenyl-, Thiophen-, Bithiophen-, Furan-, Bifuran-, Pyridin-, Bipyridin-, Terpyridin-, Fluoren-, Fluorenongruppe oder unter Mischungen von diesen ausgewählt ist, und
- B für ein Gegenion steht,
- m ein ganzzahliger Wert von einschließlich 0 bis 5 ist,
- p ein ganzzahliger Wert ist.

2. Diazoniumsalze nach Anspruch 1, **dadurch gekennzeichnet, dass** B für eine Chlorat-, Fosylat-, Sulfonatgruppe, ein anionisches Polymer, PF₆ oder BF₄ steht.

3. Diazoniumsalze nach Anspruch 1, **dadurch gekennzeichnet, dass** B für eine PF₆- oder BF₄-Gruppe steht.

4. Diazoniumsalze nach einem der vorherigen Ansprüche, **dadurch gekennzeichnet, dass** sie eine der nachfolgenden allgemeinen Formeln I-2 bis I-7 haben: 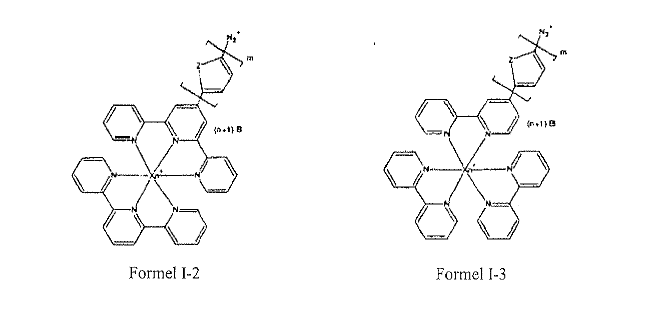 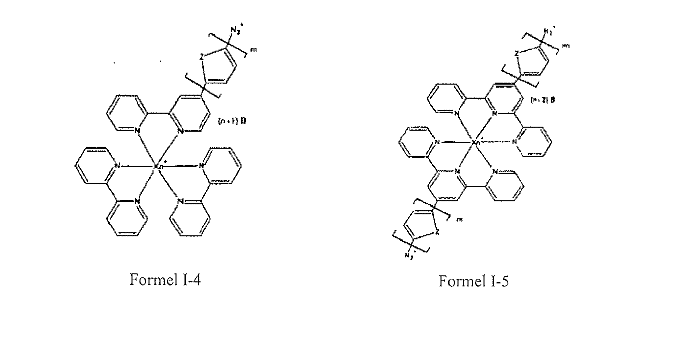 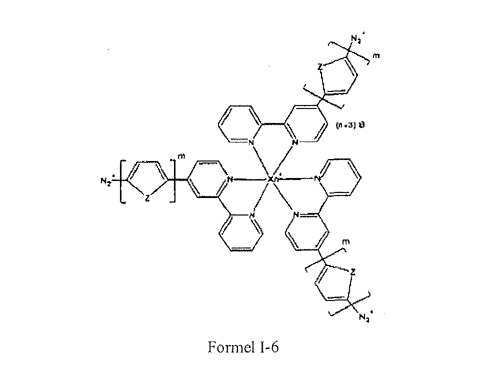 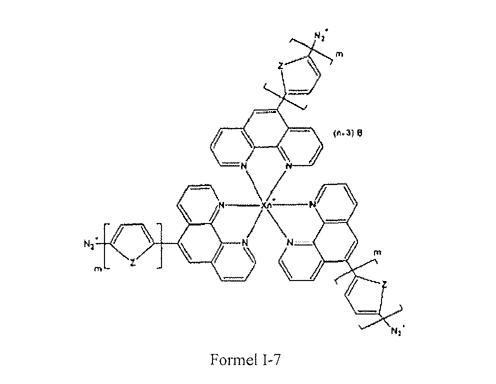 in denen:
- X unter Ruthenium (Ru), Osmium (Os), Eisen (Fe), Cobalt (Co) und Iiridium (Ir) ausgewählt ist,
- Z für CH=CH, S, O, CH=N, N-H, N = N steht, und
- m ein ganzzahliger Wert von einschließlich 0 bis 5 ist, und
- B für BF₄ oder PF₆ steht.

5. Diazoniumsalze nach einem der Ansprüche 1 bis 3, **dadurch gekennzeichnet, dass** sie eine der nachfolgenden allgemeinen Formeln I-8 bis I-12 haben: 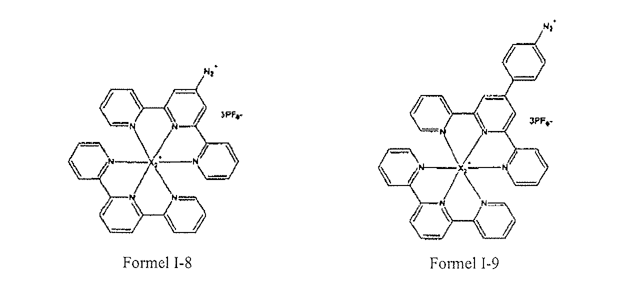 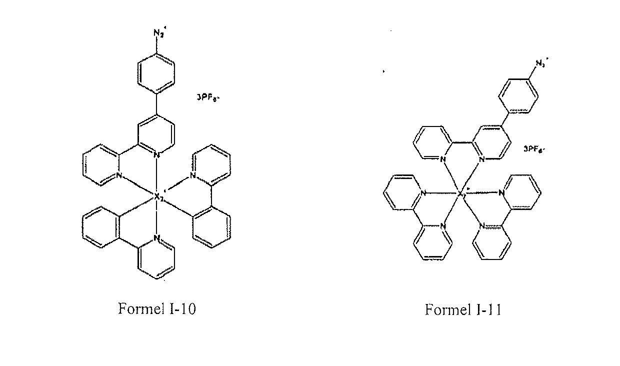 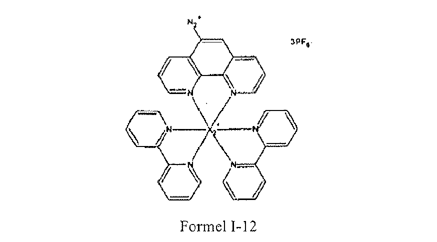 in denen X unter Ruthenium (Ru) und Osmium (Os) ausgewählt ist, und B für PF₆ steht.

6. Diazoniumsalze nach einem der Ansprüche 1 bis 3, **dadurch gekennzeichnet, dass** sie eine der nachfolgenden allgemeinen Formeln I-13 bis I-14 haben: 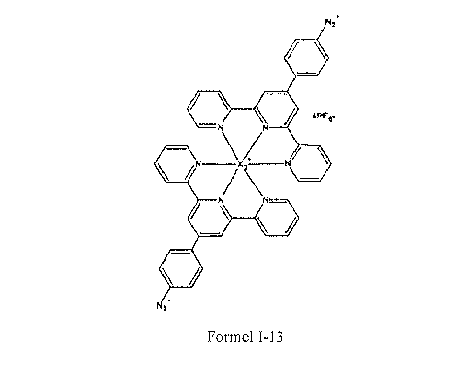 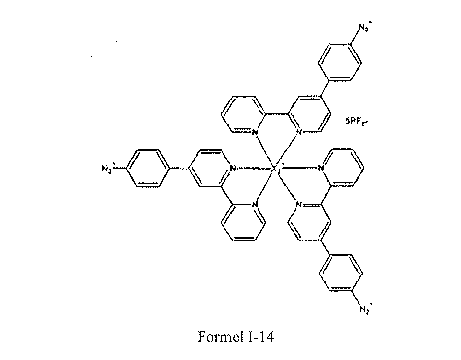 in denen X unter Eisen (Fe), Ruthenium (Ru) und Osmium (Os) ausgewählt ist, und B für PF₆ steht.

7. Diazoniumsalz nach einem der Ansprüche 1 bis 3, **dadurch gekennzeichnet, dass**:
- X für Ruthenium (Ru) steht,
- L für eine Bipyridinguppe steht,
- n = 2
- E für eine Bipyridin-Phenyl-Gruppe steht,
- m = 1,
- p = 1,
- B = PF₆,
mit der nachfolgenden allgemeinen Formel (I-15):
[Ru(Bipyridin)₂(Bipyridin-Phenyl-N2⁺)] [PF₆]₃ Formel I-15.

8. Diazoniumsalz nach einem der Ansprüche 1 bis 3, **dadurch gekennzeichnet, dass**:
- X für Iridium (Ir) steht,
- L für eine Phenylpyridingruppe steht,
- n = 2
- E für eine Bipyridin-Phenyl-Gruppe steht,
- m = 1,
- p = 1,
- B = PF₆,
mit der nachfolgenden allgemeinen Formel (I-16):
[Ir(Phenylpyridin)₂(Bipypyridin-Phenyl-N₂⁺)][PF₆]₂ Formel I-16

9. Verfahren für die Synthese von Diazoniumsalzen nach einem der vorherigen Ansprüche, **dadurch gekennzeichnet, dass** es die folgenden Schritte umfasst:
- (a) Synthetisieren des gewünschen Metallkomplexes der Formel XLₙ, wobei alle Liganden L mindestens eine aromatische Aminfunktion aufweisen und identisch oder verschieden sein können, und
- (b) Überführen der Aminfunktionen in N₂⁺ unter Verwendung von NOBF₄.

10. Verfahren zur Ausbildung einer Monoschicht von Polymer, das Redoxeigenschaften und im sichtbaren Bereich Absorptionseigenschaften besitzt, auf einer leitenden oder halbleitenden Oberfläche, **dadurch gekennzeichnet, dass** es umfasst: einen Schritt des elektrochemischen Aufpfropfens eines Diazoniumsalzes nach einem der Ansprüche 1 bis 8, und einen Schritt des Polymerisierens dieses Diazoniumsalzes, um einen Polymerfilm mit der gewünschten Dicke zu erhalten.

11. Verfahren zur Ausbildung von Mehrfachschichten von Polymeren, die Redoxeigenschaften und im sichtbaren Bereich Absorptionseigenschaften besitzen, auf einer leitenden oder halbleitenden Oberfläche, **dadurch gekennzeichnet, dass** es die folgenden Schritte umfasst:
(a) elektrochemisches Aufpfropfen eines polymerisierbaren Diazoniumsalzes nach einem der Ansprüche 1 bis 8 auf die genannte Oberfläche,
(b) Polymerisieren dieses Diazoniumsalzes zum Ausbilden eines ersten Polymerfilms mit der gewünschten Dicke,
(c) mindestens einen Schritt des Aufpfropfens eines polymerisierbaren Diazoniumsalzes nach einem der Ansprüche 1 bis 8 auf den in Schritt (a) erhaltenen Film, wobei dieses Diazoniumsalz mit dem in Schritt (a) verwendeten Diazoniumsalz identisch oder davon verschieden ist, und
(d) Polymerisieren dieses Diazoniumsalzes zum Ausbilden eines zweiten Polymerfilms mit der gewünschten Dicke.

12. Verfahren nach Anspruch 10 oder 11, **dadurch gekennzeichnet, dass** die halbleitende Oberfläche eine Silicium- oder Platinoberfläche ist.

13. Verfahren nach Anspruch 10 oder 11, **dadurch gekennzeichnet, dass** die halbleitende Oberfläche die Oberfläche eines Kohlenstoff-Nanoröhrchens ist.

14. Verfahren nach Anspruch 10 oder 11, **dadurch gekennzeichnet, dass** die halbleitende Oberfläche die Oberfläche eines Nanopartikels von Titanoxid (TiO₂), Zinnoxid (SnO₂), Zinkoxid (ZnO) oder Zirconium(IV)-oxid (ZrO₂) ist.

15. Substrat, **dadurch gekennzeichnet, dass** es mindestens eine Oberfläche aufweist, die mindestens eine Schicht aus Polymer aufweist, welches aus einem polymerisierbaren Diazoniumsalz nach einem der Ansprüche 1 bis 8 erhalten wurde.

16. Vorrichtung, **dadurch gekennzeichnet, dass** sie mindestens ein Substrat nach Anspruch 15 aufweist.

17. Photovoltaische Zelle, insbesondere vom Grätzel-Typ, **dadurch gekennzeichnet, dass** sie mindestens ein Substrat nach Anspruch 15 aufweist.

18. Informationsspeicherzelle mit Redoxaktivität, **dadurch gekennzeichnet, dass** sie mindestens ein Substrat nach Anspruch 15 aufweist.

19. Breitband-Halbleitervorrichtung, **dadurch gekennzeichnet, dass** sie mindestens ein Substrat nach Anspruch 15 aufweist.

20. Photovoltaische Zelle vom Grätzel-Typ, **dadurch gekennzeichnet, dass** sie einen festen Elektrolyten aufweist, der mindestens ein polymerisierbares Diazoniumsalz nach einem der Ansprüche 1 bis 8 aufweist.

21. Fester leitender Elektrolyt, **dadurch gekennzeichnet, dass** er mindestens ein Diazoniumsalz nach einem der Ansprüche 1 bis 8 aufweist.
